# EUROPÄISCHE PATENTSCHRIFT

(11) **EP 2 219 911 B1**
(45) Veröffentlichungstag und Bekanntmachung des Hinweises auf die Patenterteilung: **11.02.2015**
(21) Anmeldenummer: 08856239.2
(22) Anmeldetag: 16.10.2008
(51) Int. Cl.: H01R 12/58, H05K 3/32, B60T 8/36

(54) **ANSCHLUSSELEMENT UND ZUGEHÖRIGE FLUIDBAUGRUPPE**
CONNECTING ELEMENT AND RELATED FLUID ASSEMBLY
ELÉMENT DE RACCORDEMENT ET SYSTÈME HYDRAULIQUE ASSOCIÉ

(30) Priorität: 04.12.2007 DE 102007058243
(43) Veröffentlichungstag der Anmeldung: 25.08.2010
(73) Patentinhaber: Robert Bosch GmbH, 70442 Stuttgart (DE)
(72) Erfinder: SCHALOWSKI, Gerhard, 72581 Dettingen (DE); KELLNER, Bernd, 87448 Waltenhofen (DE); WEEBER, Volker, 74348 Lauffen A. N. (DE); FUERST, Rainer, 87509 Immenstadt (DE); FRESSER, Heiko, 70599 Stuttgart (DE); HAAS, Martin, 71720 Oberstenfeld (DE); MAILAENDER, Wolfgang, 71282 Hemmingen (DE); LUTZ, Bernd, 87437 Kempten (DE)
(86) Internationale Anmeldenummer: PCT/EP2008/063921
(87) Internationale Veröffentlichungsnummer: WO 2009/071381

(56) Entgegenhaltungen:
- WO-A-00/53475
- WO-A-02/055355
- DE-A1- 19 619 968
- DE-A1- 19 929 209

## Beschreibung

### Stand der Technik

Die Erfindung betrifft ein Anschlusselement zur elektrischen Verbindung eines ersten Bauelements mit einem zweiten Bauelement nach der Gattung des unabhängigen Patentanspruchs 1 und eine zugehörige Fluidbaugruppe.

Eine herkömmliche Fluidbaugruppe, die beispielsweise in einem Antiblockiersystem (ABS) oder einem Antriebsschlupfregelsystem (ASR-System) oder einem elektronischen Stabilitätsprogrammsystem (ESP-System) eingesetzt wird, umfasst in der Regel ein Steuergerät und einen Fluidbereich, der mindestens eine Fluidkomponente, die beispielsweise als Fluidblock oder als Pumpenmotor ausgeführt ist, und mindestens ein Fluidstellelement umfasst, das beispielsweise als Ventilpatrone ausgeführt ist, die Teil eines zugehörigen Magnetventils ist. Zur Ansteuerung der mindestens einen Fluidkomponente und des mindestens einen Fluidstellelements umfasst das Steuergerät eine Leiterplatte, die gleichzeitig als Schaltungsträger sowie zur Anbindung eines am Gehäuse befindlichen Kundensteckers und der Magnetventile verwendet werden. Zudem umfasst das Steuergerät Magnetbaugruppen die ebenfalls Teil des jeweils zugehörigen Magnetventils sind und zur Verstellung der als Ventilpatronen ausgeführten Fluidstellelemente erforderlich sind. Die Magnetbaugruppen erzeugen über elektrische Magnetspulen jeweils eine Magnetkraft, über welche die Fluidstellelemente verstellbar sind, die entsprechende Volumenströme einstellen, die in Fluidkanälen der als Fluidblock ausgeführten Fluidkomponente beführt werden. Die Magnetspulen bestehen üblicherweise aus einem Eisenkreis, einem Wicklungsträger und einer Drahtwicklung und können mit elektronischen Schaltungen auf der Leiterplatte elektrisch verbunden werden. Die elektrischen Magnetspulen der Magnetbaugruppen werden über ein Stanzgitter kontaktiert, das mit mindestens einer elektronischen Schaltung der Leiterplatte elektrisch verbunden ist, wobei die über das Stanzgitter mit der Leiterplatte elektrisch verbundenen Magnetbaugruppen auf die als Ventilpatronen ausgeführten Fluidstellelemente aufgesteckt werden, die beispielsweise mit der als Fluidblock ausgeführten Fluidkomponente fest verbunden vorzugsweise verstemint sind. Das verwendete konstruktiv und werkzeugtechnisch sehr aufwändige Stanzgitter ist sehr unflexibel und kann während der Prozesslebensdauer nur schwer verändert werden. Zudem ist in Verbindung mit der Leiterplattentechnik ein weiteres elektrisches Verbindungsstück, beispielsweise in Form einzelner Anschlusspins, zwischen dem Stanzgitter und der Leiterplatte erforderlich.

So wird in der Offenlegungsschrift DE 44 12 664 A1 beispielsweise eine elektrohydraulische Druckeinstellvorrichtung für eine schlupfgeregelte Fahrzeugbremsanlage beschrieben. Die beschriebene Druckeinstellvorrichtung weist wenigstens ein mit dem Ventilblock vereinigtes Ventil mit einem vom Ventilblock aufragenden Ventildom auf, auf den eine in einem Deckel angeordnete Spule steckbar ist. Von der Spule sowie dem Deckel gehen elektrische Kontaktelemente aus, welche stoffschlüssig miteinander verbunden sind. Die elektrischen Kontaktelemente der Spule und des Deckels sind nachgiebig ausgebildet. Sie übernehmen sowohl die elektrische Verbindung als auch die Haltefunktion für die Spule. Ferner gestatten sie das Ausrichten der Spule beim Stecken auf den Ventildom. Die elektrischen Kontaktelemente des Deckels sind als Stanzgitterstreifen ausgeführt, die in den aus einem isolierenden Werkstoff bestehenden Deckel eingegossen sind. Die Stanzgitterstreifen erstrecken sich rechtwinklig zur Längsachse der Spule verlaufenden Ebene und weisen mäanderförmige Abkröpfungen auf, wodurch die Stanzgitterstreifen eine relativ hohe elastische Nachgiebigkeit in einer rechtwinkligen zur Längsachse der Spule verlaufenden Ebene aufweisen. Die Stanzgitterstreifen weisen an ihrem freien Ende eine Befestigungsfahne auf, welche parallel zum zugeordneten Anschlussdraht der Spule verläuft und mit diesem durch eine stoffschlüssige Verbindung wie Schweißen bzw. Löten verbunden wird.

In der internationalen Patentanmeldung WO 02/055355 A2 wird beispielsweise eine Spulenanordnung für eine Fluidbaugruppe beschrieben. Die beschriebene Spulenanordnung umfasst ein Anschlusselement zur elektrischen Verbindung der Spulenanordnung eines Magnetventils mit einem Stanzgitter, wobei das Anschlusselement ein erstes elektrisches Kontaktelement zur elektrischen Kontaktierung der Spulenanordnung, ein zweites elektrisches Kontaktelement zur elektrischen Kontaktierung des Stanzgitters und ein Toleranzausgleichselement umfasst. Das Anschlusselement ist einstückig ausgeführt, wobei das Toleranzausgleichselement das erste elektrische Kontaktelement mit dem zweiten elektrischen Kontaktelement verbindet und einen Längenausgleich in mindestens eine Raumrichtung ermöglicht, um eine gewünschte räumliche Positionierung des ersten Kontaktelements und des zweiten Kontaktelements zueinander vorzugeben. Hierbei ist das erste Kontaktelement an einem Ende als Lötstelle für einen Spulendraht der Spulenanordnung ausführt.

In der internationalen Patentanmeldung WO 00/53475 A1 wird beispielsweise eine Anordnung zur Kontaktierung eines elektrischen Bauteils mit einer elektrischen Schaltung beschrieben. Insbesondere wird die Kontaktierung von Magnetventilen einer schlupfgeregelten Fahrzeugbremsanlage mit einem Stanzgitter beschrieben. Die beschriebene Kontaktierungsanordnung umfasst ein Anschlusselement zur elektrischen Verbindung eines Magnetventils mit dem Stanzgitter, wobei das Anschlusselement ein erstes elektrisches Kontaktelement zur elektrischen Kontaktierung des Magnetventils, ein zweites elektrisches Kontaktelement zur elektrischen Kontaktierung des Stanzgitters und ein Toleranzausgleichselement umfasst. Das Anschlusselement ist einstückig ausgeführt, wobei das Toleranzausgleichselement das erste elektrische Kontaktelement mit dem zweiten elektrischen Kontaktelement verbindet und einen Längenausgleich in mindestens eine Raumrichtung ermöglicht, um eine gewünschte räumliche Positionierung des ersten Kontaktelements und des zweiten Kontaktelements zueinander vorzugeben.

In der Offenlegungsschrift DE 199 29 209 A1 wird beispielsweise ein elektronisches Steuergerät mit Kühlkörper für eine hydraulische Fahrzeugbremse schrieben. Das beschriebene Steuergerät umfasst ein Anschlusselement zur elektrischen Verbindung einer Ventilspule mit einem Schaltungsträger, wobei das Anschlusselement ein erstes elektrisches Kontaktelement zur elektrischen Kontaktierung des Magnetventils, ein zweites elektrisches Kontaktelement zur elektrischen Kontaktierung der Leiterplatte und mindestens ein Toleranzausgleichselement umfasst. Das Anschlusselement ist einstückig ausgeführt und das erste elektrische Kontaktelement und das zweite elektrische Kontaktelement sind über das mindestens eine Toleranzausgleichselement miteinander verbunden. Hierbei ermöglicht ein erstes veränderbares Toleranzausgleichselement einen Längenausgleich in mindestens eine Raumrichtung, um eine gewünschte räumliche Positionierung des ersten Kontaktelements und des zweiten Kontaktelements zueinander vorzugeben, wobei das zweite Kontaktelement an einem Ende als Steckeranschluss ausgerührt ist, der zur Herstellung einer elektrischen und mechanischen Verbindung in eine korrespondierende Steckeraufnahme in der Leiterplatte einführbar ist, wobei die Längsachse des ersten

Kontaktelements und die Längsachse des zweiten Kontaktelements im Wesentlichen senkrecht zueinander verlaufen.

In der Offenlegungsschrift DE 196 19 968 A1 wird beispielsweise eine Druckregelvorrichtung mit einem Ventilaufnahmekörper, an dem wenigstens eine Ventilspule angebracht ist, und mit einem auf den Ventilaufnahmekörper aufgesetzten Gehäuse beschrieben, das die Ventilspule abdeckt. Die Ventilspule ist mittels Anschlusselementen mit einer elektrischen Schaltung im Gehäuse verbunden. Die Anschlusselemente umfassen jeweils ein erstes elektrisches Kontaktelement zur elektrischen Kontaktierung der Ventilspule, ein zweites elektrisches Kontaktelement zur elektrischen Kontaktierung der elektrischen Schaltung und mindestens ein Toleranzausgleichselement. Das Anschlusselement ist einstückig ausgeführt und das erste elektrische Kontaktelement und das zweite elektrische Kontaktelement sind über das mindestens eine Toleranzausgleichselement miteinander verbunden. Hierbei ermöglicht ein erstes veränderbares Toleranzausgleichselement einen Längenausgleich in mindestens eine Raumrichtung, um eine gewünschte räumliche Positionierung des ersten Kontaktelements und des zweiten Kontaktelements zueinander vorzugeben, wobei das zweite Kontaktelement an einem Ende als Steckeranschluss ausgeführt ist, der zur Herstellung einer elektrischen und mechanischen Verbindung in eine korrespondierende Steckeraufnahme in der Leiterplatte einführbar ist.

### Offenbarung der Erfindung

Das erfindungsgemäße Anschlusselement zur elektrischen Verbindung einer Magnetspule eines Magnetventils mit einer Leiterplatte mit den Merkmalen des unabhängigen Patentanspruchs 1 hat demgegenüber den Vorteil, dass das Anschlusselement einstückig ausgeführt ist und ein erstes elektrisches Kontaktelement zur elektrischen Kontaktierung der Magnetspule und ein zweites elektrisches Kontaktelement zur elektrischen Kontaktierung der Leiterplatte über mindestens ein Toleranzausgleichselement miteinander verbunden sind, wobei ein erstes veränderbares Toleranzausgleichselement einen Längenausgleich in mindestens eine Raumrichtung ermöglicht, um eine gewünschte räumliche Positionierung des ersten Kontaktelements und des zweiten Kontaktelements zueinander vorzugeben. Das zweite Kontaktelement ist an einem Ende als Steckeranschluss ausgeführt, der zur Herstellung einer elektrischen und mechanischen Verbindung in eine korrespondierende Steckeraufnahme in der Leiterplatte einführbar ist. Erfindungsgemäß weist das als Steckeranschluss ausgeführte zweite Kontaktelement am anderen Ende ein mechanisches Verbindungselement auf, mit dem das zweite Kontaktelement in einen Durchbruch eines

Zwischenbodens einpressbar ist. Das mindestens eine erste Toleranzausgleichselement erstreckt sich im Wesentlichen rechtwinklig zur Längsachse des ersten Kontaktelements und zur Längsachse des zweiten Kontaktelements, so dass die Längsachsen der beiden Kontaktelemente und im Wesentlichen parallel versetzt zueinander verlaufen.

Eine Fluidbaugruppe mit einem erfindungsgemäßen Anschlusselement zur elektrischen Verbindung einer Magnetbaugruppe eines Magnetventils mit einer Leiterplatte eines Steuergeräts mit den Merkmalen des unabhängigen Patentanspruchs 5 weist den Vorteil auf, dass eine Magnetspule der Magnetbaugruppe über mindestens ein erfindungsgemäßes Anschlusselement elektrisch mit der Leiterplatte verbunden ist, wobei das erste Kontaktelement des Anschlusselements jeweils mit einem Anschlussdom der Magnetbaugruppe verbunden ist, und das zweite elektrische Kontaktelement des Anschlusselements mit einem Kontaktbereich der Leiterplatte verbunden ist. Die Magnetbaugruppe wird nach der elektrischen Verbindung mit der Leiterplatte auf eine über einen Fluidblock der Fluidbaugruppe ragende Ventilpatrone aufgesteckt, wobei ein erstes veränderbares Toleranzausgleichselement, welches das erste Kontaktelement mit dem zweiten Kontaktelement verbindet, einen Längenausgleich in mindestens eine Raumrichtung ermöglicht, um eine gewünschte räumliche Positionierung des ersten Kontaktelements und des zweiten Kontaktelements zueinander vorzugeben und vorhandene Lagetoleranzen auszugleichen, da die Magnetspule die im Fluidblock befestigte Ventilpatrone mit einem radialen Spiel umschließt. Das zweite Kontaktelement ist an einem Ende als Steckeranschluss ausgeführt, der zur Herstellung einer elektrischen und mechanischen Verbindung in eine korrespondierende Steckeraufnahme in der Leiterplatte eingeführt ist. Des Weiteren weist das als Steckeranschluss ausgeführte zweite Kontaktelement am anderen Ende erfindungsgemäß ein mechanisches Verbindungselement auf, mit dem das zweite Kontaktelement in einen Durchbruch eines Zwischenbodens des Steuergeräts einpresst ist. Das mechanische Verbindungselement kann beispielsweise über eine Rastkontur mit Überpressung mit dem Zwischenboden des Steuergerätes verbunden werden. Dadurch können die beiden Kontaktelemente des Anschlusselements in vorteilhafter Weise mechanisch entkoppelt werden, so dass ausgehend von der Magnetbaugruppe keine mechanischen Kräfte auf die elektrische Kaltkontaktierung des zweiten Kontaktelements in der Leiterplatte übertragen werden. Des Weiteren kann das Toleranzausgleichselement durch Temperaturänderungen verursachte Längenänderungen kompensieren. Mit dem erfindungsgemäßen Anschlusselement kann die Magnetspule in vorteilhafter Weise ohne Stanzgitter und ohne Schweiß- bzw. Lötvorgang direkt mit der Leiterplatte elektrisch verbunden werden.

Durch die in den abhängigen Ansprüchen aufgeführten Maßnahmen und Weiterbildungen sind vorteilhafte Verbesserungen des im unabhängigen Patentanspruch 1 angegebenen Anschlusselements und der im unabhängigen Patentanspruch 7 angegebenen Fluidbaugruppe möglich.

Besonders vorteilhaft ist, dass die beiden Kontaktelemente unterschiedliche Kaltkontaktierungsarten umsetzen, wobei die Kaltkontaktierungsarten eine Schneidklemmverbindung und/oder eine Steckverbindung umfassen. Durch die Verwendung einer Schneidklemmverbindung ist es nicht mehr erforderlich, den Isolationslack des Spulendrahtes an den Drahtenden der Wicklung abzuisolieren. Zudem sind bei einer Schneidklemmverbindung bzw. Steckverbindung keine störanfälligen thermischen Prozesse erforderlich, wodurch die Prozessüberwachung und die Prozesseinrichtungen kostengünstiger realisiert werden können.

Das erfindungsgemäße Anschlusselement ist beispielsweise als einstückiges Stanzteil ausgeführt, das einfach und kostengünstig hergestellt werden kann.

In Ausgestaltung des erfindungsgemäßen Anschlusselements umfasst das erste Kontaktelement zur Herstellung der elektrischen Schneidklemmverbindung mit dem Spulendraht beispielsweise ein Schneidelement. Zudem umfasst das erste Kontaktelement ein angeformtes mechanisches Verbindungselement, um das erste Kontaktelement mechanisch mit einer korrespondierenden Kontaktaufnahme der Magnetbaugruppe zu verbinden.

In Ausgestaltung der erfindungsgemäßen Fluidbaugruppe wird das erste Kontaktelement mit dem Schneidelement in einen korrespondierenden Anschlussdom eingeführt, wobei das Schneidelement in einem Fügeschritt den Isolationslack des Spulendrahtes abschabt und durch eine Überpressung eine gasdichte elektrische Verbindung zwischen dem ersten Kontaktelement und dem Spulendraht herstellt. Das angeformte mechanische Verbindungselement stellt beispielsweise über eine Außenverzahnung die mechanische Verbindung innerhalb des korrespondierenden Anschlussdoms der Magnetbaugruppe her.

In weiterer Ausgestaltung der erfindungsgemäßen Fluidbaugruppe führt das erste zwischen dem ersten elektrischen Kontaktelement und dem zweiten elektrischen Kontaktelement angeordnete Toleranzausgleichselement einen Längenausgleich in mindestens eine Raumrichtung aus, um eine gewünschte räumliche Positionierung des ersten Kontaktelements und des zweiten Kontaktelements zueinander vorzugeben, wobei ein seitlicher Abstand zwischen den beiden Kontaktelementen so gewählt ist, dass das zweite Kontaktelement mit dem mechanischen Verbindungselement seitlich über die Magnetbaugruppe übersteht. Ein zwischen dem zweiten Kontaktelement und dem mechanischen Verbindungselement angeordnetes zweites Toleranzausgleichselement führt einen Längenausgleich zwischen der Leiterplatte und dem Zwischenboden des Steuergeräts aus.

Vorteilhafte Ausführungsformen der Erfindung sind in den Zeichnungen dargestellt und werden nachfolgend beschrieben. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Schnittdarstellung einer erfindungsgemäßen Fluidbaugruppe.
Fig. 2 zeigt eine schematische Darstellung eines erfindungsgemäßen Anschlusselements.
Fig. 3 zeigt eine schematische Perspektivdarstellung einer Magnetbaugruppe für die erfindungsgemäße Fluidbaugruppe gemäß Fig. 1.
Fig. 4 zeigt eine schematische Darstellung eines Gurts mit mehreren erfindungsgemäßen Anschlusselementen.
Fig. 5 bis 8 zeigen verschiedene Ausführungsformen des erfindungsgemäßen Anschlusselements.

### Ausführungsformen der Erfindung

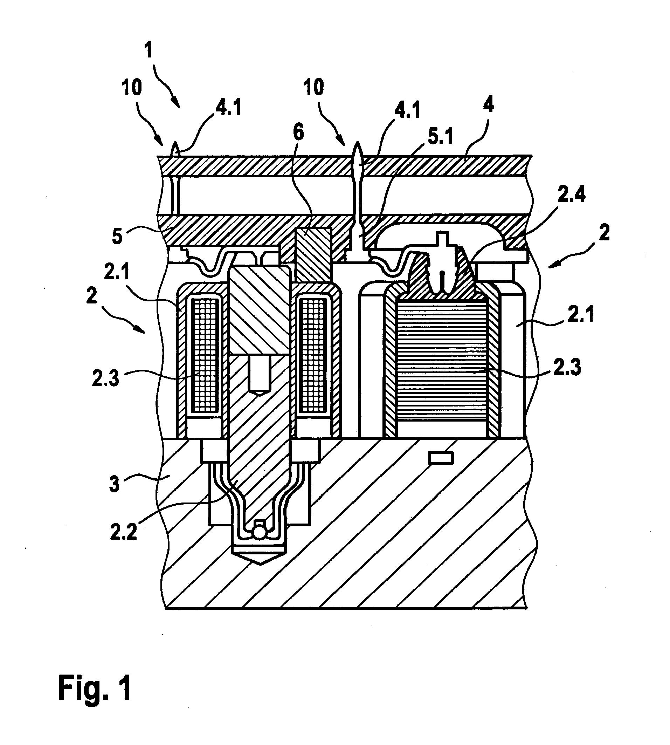

Wie aus Fig. 1 ersichtlich ist, umfasst eine erfindungsgemäße Fluidbaugruppe 1 einen Fluidblock 3, eine in einem Steuergerät angeordnete Leiterplatte 4 und mehrere Magnetventile 2, von denen zwei Magnetventile 2 dargestellt sind. Die Magnetventile 2 umfassen jeweils eine Magnetbaugruppe 2.1 mit einer Magnetspule 2.3 und zwei Anschlussdomen 2.4 und eine im Fluidblock 3 befestigte Ventilpatrone 2.2. Die Magnetbaugruppen 2.1 der Magnetventile 2 sind jeweils auf die über den Fluidblock 3 ragenden Ventilpatronen 2.2 aufgesteckt. Die Magnetspulen 2.3 der Magnetbaugruppen 2.1 sind jeweils über zwei erfindungsgemäße Anschlusselemente 10 elektrisch mit der Leiterplatte 4 verbunden. Wie aus Fig. 1 weiter ersichtlich ist, werden die Magnetbaugruppen 2 jeweils durch ein elastisches Halteelement 6, das sich am Zwischenboden 5 des Steuergerätegehäuses abstützt, auf den Fluidblock 3 gepresst, um eine Schwingungsbelastung der Anschlusselemente 10 zu verhindern bzw. zu reduzieren.

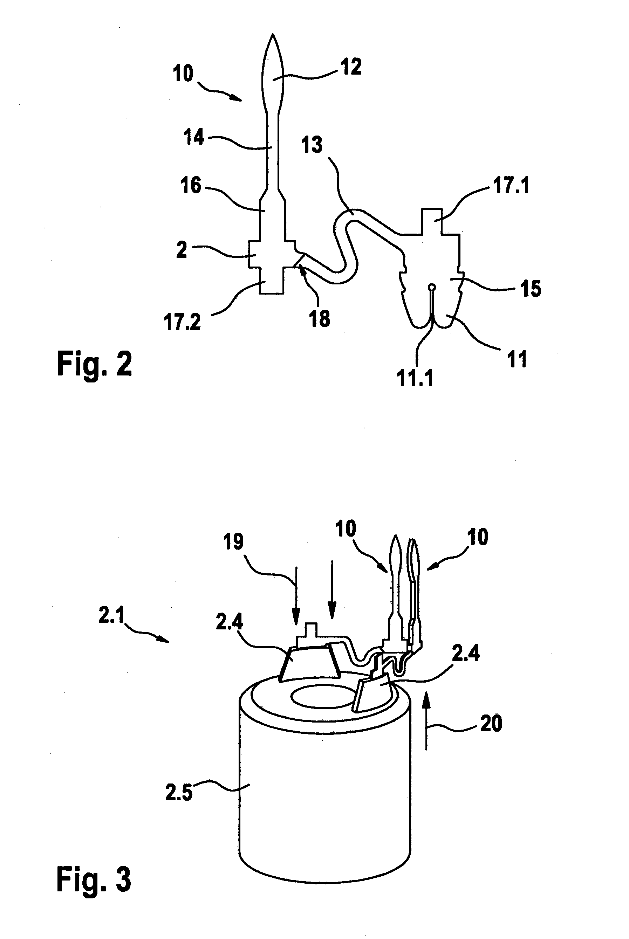

Wie aus Fig. 2 ersichtlich ist, umfasst ein erfindungsgemäßes Anschlusselement 10 zur elektrischen Verbindung der Magnetspule 2.3 mit der Leiterplatte 4 ein erstes elektrisches Kontaktelement 11 zur elektrischen Kontaktierung der Magnetspule 2.3 und ein zweites elektrisches Kontaktelement 12 zur elektrischen Kontaktierung der Leiterplatte 4, wobei die beiden Kontaktelemente 11, 12 über ein erstes Toleranzausgleichselement 13 und ein zweites Toleranzausgleichselement 14 miteinander verbunden sind.

Wie aus Fig. 2 weiter ersichtlich ist, ist das Anschlusselement 10 im dargestellten Ausführungsbeispiel als einstückiges Stanzteil ausgeführt. Die beiden Kontaktelemente 11, 12 setzen unterschiedliche Kaltkontaktierungsarten um, wobei das erste Kontaktelement 11 ein Schneidelement 11.1 zur Herstellung einer elektrischen Schneidklemmverbindung mit einem Spulendraht der Magnetspule 2.3 und ein angeformtes mechanisches Verbindungselement 15 umfasst, um das erste Kontaktelement 11 mechanisch mit dem korrespondierenden Anschlussdom 2.4 der Magnetbaugruppe 2.1 zu verbinden. Das zweite Kontaktelement 12 ist an einem Ende als Steckeranschluss ausgeführt, der zur Herstellung einer elektrischen und mechanischen Verbindung in eine korrespondierende in Fig. 1 dargestellte Steckeraufnahme 4.1 in der Leiterplatte 4 einführbar bzw. einpressbar ist, um die Kaltkontaktierung des Steckeranschlusses und der Steckeraufnahme 4.1 umzusetzen. Am anderen Ende weist das als Steckeranschluss ausgeführte zweite Kontaktelement 12 ein mechanisches Verbindungselement 16 auf, mit dem das zweite Kontaktelement 12 in einen Durchbruch 5.1 eines Zwischenbodens 5 des Steuergeräts einpressbar ist. Das erste veränderbare Toleranzausgleichselement 13 ermöglicht einen Längenausgleich in mindestens eine Raumrichtung, um eine gewünschte räumliche Positionierung des ersten Kontaktelements 12 und des zweiten Kontaktelements 13 zueinander vorzugeben. Das zweite Toleranzausgleichselement 14 ist zwischen dem zweiten Kontaktelement 12 und dem mechanischen Verbindungselement 16 angeordnet und ermöglicht einen Längenausgleich zwischen der Leiterplatte 4 und dem Zwischenboden 5 des Steuergeräts.

Wie aus Fig. 2 weiter ersichtlich ist, kann das zweite Kontaktelement 12 in Abhängigkeit von der Ausführung der Steckeraufnahme 4.1 bzw. der Einpresszone in der Leiterplatte 4 eine vom ersten Kontaktelement 11 unterschiedlich definierte Materialdicke aufweisen, so dass zwischen dem zweiten Kontaktelement 12 und dem ersten Toleranzausgleichselement 13 ein Materialdickensprung 18 auftritt. Der Materialdickesprung 18 kann beispielsweise durch eine Frässtufe realisiert werden.

Somit verbinden die erfindungsgemäßen Anschlusselemente 10 die Magnetspulen 2.3 der Magnetbaugruppen 2.1 elektrisch mit der Elektronik auf der Leiterplatte 4. Mechanisch ist das Anschlusselement 10 beispielsweise über ein als Rastkontur ausgeführtes mechanisches Verbindungselement 16 mit Überpressung mit einem Durchbruch 5.1 im Zwischenboden 5 des Steuergerätes verbunden. Dies gewährleistet, dass ausgehend von der Magnetspule 2.3 keine mechanischen Kräfte auf die elektrische Kaltkontaktierung des zweiten Kontaktelements 12 in der Leiterplatte 4 übertragen werden. Die Schneidklemmverbindung des ersten Kontaktelements 11 mit dem Anschlussdom 2.4 ist so ausgeformt, dass im als Schlitz ausgeführten Schneidelement 11.1 die elektrische Kaltkontaktierung mit dem Spulendraht der Magnetspule 2.3 erfolgt und an dem als Außenverzahnung ausgeführten mechanischen Verbindungselement 15 die mechanische Verbindung mit dem Anschlussdom 2.4 der Magnetbaugruppe 2.1 hergestellt wird.

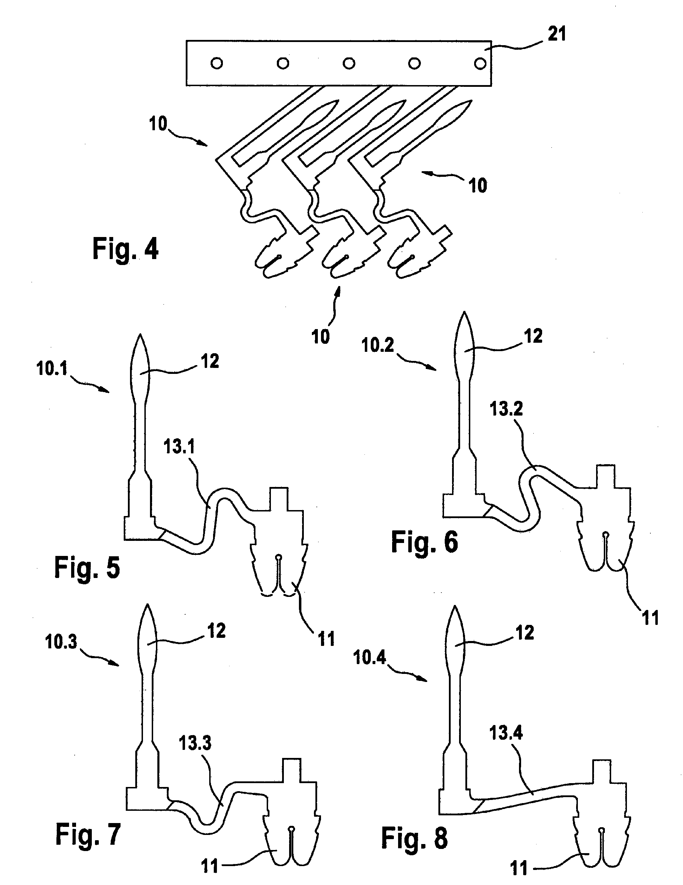

Wie aus Fig. 3 ersichtlich ist, umfasst eine beispielhaft dargestellte Magnetbaugruppe 2.1 zwei Anschlussdome 2.4 und einen Gehäusemantel 2.5, der die auf einen Wickelkörper gewickelte Magnetspule 2.3 abdeckt. Zur Montage der beiden Anschlusselemente 10 zur Kontaktierung der Magnetbaugruppe 2.1 werden die Anschlusselemente 10, wie aus Fig. 4 ersichtlich ist, an einem Gurt 21 angeliefert, vereinzelt und mit einem Greifer an einer ersten Greiferposition 17.1 über dem ersten Kontaktelement 11 erfasst und in den korrespondierenden Anschlussdom 2.4 der Magnetbaugruppe 2.1 geschoben, wie in Fig. 3 durch die Richtungspfeile 19 angezeigt wird, wobei durch die Schneidklemmverbindung der elektrische Kontakt des ersten Kontaktelements 11 zum Spulendraht hergestellt wird. Das seitliche Herausführen der Anschlusselemente 10 über den Durchmesser der Magnetbaugruppe 2.1 hinaus, ermöglicht ein direktes Erfassen des Anschlusselements 10 an einer zweiten Greiferposition 17.2 unterhalb des zweiten Kontaktelements 12 und das kraftunterstützte Einpressen des Anschlusselements 10 mitsamt der Magnetbaugruppe 2.1 in den Zwischenboden 5 des Steuergerätegehäuses entlang des Richtungspfeils 20. Zudem können über diese Greiferposition 17.2 die Kräfte, welche während des Aufpressens der Leiterplatte 4 auf das zweite Kontaktelement 12 einwirken, aufgenommen werden. Die Magnetspule 2.3 umschließt die im Fluidblock 3 befestigte Ventilpatrone 2.2 mit einem sehr geringen radialen Spiel, so dass die Lage der im Steuergerät vormontierten Magnetspule 2.3 direkt durch die Lagetoleranzen der Ventilpatrone beeinflusst wird. Da die Verrastpositionen der Anschlusselemente 10 im Zwischenboden 5 des Steuergerätegehäuses unabhängig von diesen Toleranzen sind, weisen die Anschlusselemente 10 durch die ersten Toleranzausgleichselemente 13 die Möglichkeit eines einmaligen Toleranzausgleiches bei der Montage auf. So können die zweiten Kontaktelemente 12 über die zweite Greiferposition 17.2 erfasst und durch Verformen der ersten Toleranzausgleichselemente 13 zur Montage in den korrespondierenden Durchbruch 5.1 im Zwischenboden 5 des Steuergerätegehäuses ausgerichtet werden. Die ersten Toleranzausgleichselemente 13 erstrecken sich jeweils im Wesentlichen rechtwinklig zur Längsachse des ersten Kontaktelements 11 und zur Längsachse des zweiten Kontaktelements 12, so dass die Längsachsen der beiden Kontaktelemente 11 und 12 im Wesentlichen parallel zueinander verlaufen. Das erste Toleranzausgleichselement 13 weist im dargestellten Ausführungsbeispiel zwei mäanderförmige Abkröpfungen auf, wodurch das jeweilige Anschlusselement 10 eine relativ hohe elastische Nachgiebigkeit zwischen den beiden Kontaktelementen 11, 12 aufweist. Fig. 5 bis 8 zeigen verschiedene Ausführungsbeispiele des erfindungsgemäßen Anschlusselements 10.1, 10.2, 10.3, 10.4, die verschiedene mögliche geometrische Formen für das erste Toleranzausgleichselement 13.1, 13.2, 13.3, 13.4 zeigen, wobei die praktische Ausführung des ersten Toleranzausgleichselements 13 nicht auf die dargestellten Formen begrenzt ist.

Das erfindungsgemäße Anschlusselement und die erfindungsgemäße Fluidbaugruppe führt in vorteilhafter Weise einen notwendigen Toleranzausgleich zwischen Magnetbaugruppe und Verdrahtungsebene aus, ermöglicht eine Kosteneinsparung durch Reduktion der Teile bzw. Materialmengen, Prozesse, Anlagen usw., und steigert die Flexibilität und Modularisierbarkeit für verschiedene Anwendungen, wie beispielsweise in einem Antiblockiersystem (ABS) oder einem Antriebsschlupfregelsystem (ASR-System) oder einem elektronischen Stabilitätsprogrammsystem (ESP-System). Zudem können die Platzanforderungen im Gesamtsystem reduziert werden.

## Patentansprüche

1. Anschlusselement zur elektrischen Verbindung eines Magnetventils mit einer Leiterplatte, wobei das Anschlusselement (10) ein erstes elektrisches Kontaktelement (11) zur elektrischen Kontaktierung des Magnetventils (2), ein zweites elektrisches Kontaktelement (12) zur elektrischen Kontaktierung der Leiterplatte (4) und mindestens ein Toleranzausgleichselement (13, 14) umfasst, wobei das Anschlusselement (10) einstückig ausgeführt ist und das erste elektrische Kontaktelement (11) und das zweite elektrische Kontaktelement (12) über das mindestens eine Toleranzausgleichselement (13, 14) miteinander verbunden sind, wobei ein erstes veränderbares Toleranzausgleichselement (13) einen Längenausgleich in mindestens eine Raumrichtung ermöglicht, um eine gewünschte räumliche Positionierung des ersten Kontaktelements (11) und des zweiten Kontaktelements (12) zueinander vorzugeben, wobei das zweite Kontaktelement (12) an einem Ende als Steckeranschluss ausgeführt ist, der zur Herstellung einer elektrischen und mechanischen Verbindung in eine korrespondierende Steckeraufnahme (4.1) in der Leiterplatte (4) einführbar ist, **dadurch gekennzeichnet, dass** das als Steckeranschluss ausgeführte zweite Kontaktelement (12) am anderen Ende ein mechanisches Verbindungselement (16) aufweist, mit dem das zweite Kontaktelement (12) in einen Durchbruch (5.1) eines Zwischenbodens (5) einpressbar ist, wobei sich das mindestens eine erste Toleranzausgleichselement (13) im Wesentlichen rechtwinklig zur Längsachse des ersten Kontaktelements (11) und zur Längsachse des zweiten Kontaktelements (12) erstreckt, so dass die beiden Kontaktelemente (11, 12) im Wesentlichen parallel versetzt zueinander verlaufen.

2. Anschlusselement nach Anspruch 1, **dadurch gekennzeichnet, dass** die beiden Kontaktelemente (11, 12) unterschiedliche Kaltkontaktierungsarten umsetzen, wobei die Kaltkontaktierungsarten eine Schneidklemmverbindung und/oder eine Steckverbindung umfassen.

3. Anschlusselement nach Anspruch 1 oder 2, **dadurch gekennzeichnet, dass** das Anschlusselement (10) als einstückiges Stanzteil ausgeführt ist.

4. Anschlusselement nach einem der Ansprüche 1 bis 3, **dadurch gekennzeichnet, dass** das erste Kontaktelement (11) ein Schneidelement (11.1) zur Herstellung einer elektrischen Schneidklemmverbindung mit einem Spulendraht und ein angeformtes mechanisches Verbindungselement (15) umfasst, um das erste Kontaktelement (11) mechanisch mit einer korrespondierenden Kontaktaufnahme (2.4) des Magnetventils (2) zu verbinden.

5. Fluidbaugruppe mit einem Fluidblock (3), einer in einem Steuergerät angeordneten Leiterplatte (4) und mindestens einem Magnetventil (2), das eine Magnetbaugruppe (2.1) mit einer Magnetspule (2.3) und zwei Anschlussdomen (2.4) und eine im Fluidblock (3) befestigte Ventilpatrone (2.2) umfasst, wobei die Magnetbaugruppe (2.1) auf die über den Fluidblock (3) ragende Ventilpatrone (2.2) aufgesteckt ist, **dadurch gekennzeichnet, dass** die Magnetspule (2.3) über mindestens ein Anschlusselement (10) nach einem der Ansprüche 1 bis 4 elektrisch mit der Leiterplatte (4) verbunden ist, wobei das erste Kontaktelement (11) jeweils mit einem der Anschlussdome (2.4) verbunden ist, und das zweite elektrische Kontaktelement (12) mit einem Kontaktbereich (4.1) der Leiterplatte (4) verbunden ist, wobei das an einem Ende als Steckeranschluss ausgeführte zweite Kontaktelement (12) zur Herstellung einer elektrischen und mechanischen Verbindung in eine korrespondierende Steckeraufnahme (4.1) in der Leiterplatte (4) eingeführt ist, und wobei das am anderen Ende des zweiten Kontaktelements (12) angeordnete mechanische Verbindungselement (16) in einen Durchbruch (5.1) des Zwischenbodens (5) des Steuergeräts eingepresst ist.

6. Fluidbaugruppe nach Anspruch 5, **dadurch gekennzeichnet, dass** das erste Kontaktelement (11) ein Schneidelement (11.1), das in einem korrespondierenden Anschlussdom (2.4) eine elektrische Schneidklemmverbindung mit einem Spulendraht der Magnetspule (2.3) herstellt, und ein angeformtes mechanisches Verbindungselement (15) aufweist, welches das erste Kontaktelement (11) mechanisch mit dem korrespondierenden Anschlussdom (2.4) der Magnetbaugruppe (2) verbindet.

## Claims

1. Connection element for electrically connecting a solenoid valve to a printed circuit board, wherein the connection element (10) comprises a first electrical contact element (11) for making electrical contact with the solenoid valve (2), a second electrical contact element (12) for making electrical contact with the printed circuit board (4), and at least one tolerance-compensation element (13, 14), wherein the connection element (10) is of integral design and the first electrical contact element (11) and the second electrical contact element (12) are connected to one another by means of the at least one tolerance-compensation element (13, 14), wherein a first variable tolerance-compensation element (13) permits length compensation in at least one spatial direction in order to prespecify a desired spatial positioning of the first contact element (11) and the second contact element (12) in relation to one another, wherein the second contact element (12) is designed as a plug connection at one end, it being possible for the said plug connection to be inserted into a corresponding plug receptacle (4.1) in the printed circuit board (4) in order to establish an electrical and mechanical connection, **characterized in that** the second contact element (12), which is designed as a plug connection, has a mechanical connecting element (16) at the other end, it being possible for the second contact element (12) to be pressed into an aperture (5.1) in an intermediate space (5) by way of the said mechanical connecting element, wherein the at least one first tolerance-compensation element (13) extends substantially at a right angle to the longitudinal axis of the first contact element (11) and to the longitudinal axis of the second contact element (12), and therefore the two contact elements (11, 12) run in a manner offset substantially parallel in relation to one another.

2. Connection element according to Claim 1, **characterized in that** the two contact elements (11, 12) implement different types of cold contact-making connections, with the types of cold contact-making connections comprising an insulation-displacement connection and/or a plug connection.

3. Connection element according to Claim 1 or 2, **characterized in that** the connection element (10) is designed as an integral stamped part.

4. Connection element according to one of Claims 1 to 3, **characterized in that** the first contact element (11) comprises a cutting element (11.1) for establishing an electrical insulation-displacement connection to a coil wire, and a shaped mechanical connecting element (15) in order to mechanically connect the first contact element (11) to a corresponding contact receptacle (2.4) of the solenoid valve (2).

5. Fluid assembly having a fluid block (3), a printed circuit board (4) which is arranged in a controller, and at least one solenoid valve (2) which comprises a magnet assembly (2.1), which has a magnet coil (2.3) and two connection domes (2.4), and a valve cartridge (2.2) which is mounted in the fluid block (3), wherein the magnet assembly (2.1) is fitted onto the valve cartridge (2.2), which projects beyond the fluid block (3), **characterized in that** the magnet coil (2.3) is electrically connected to the printed circuit board (4) by means of at least one connection element (10) according to one of Claims 1 to 4, wherein the first contact element (11) is respectively connected to one of the connection domes (2.4), and the second electrical contact element (12) is connected to a contact region (4.1) of the printed circuit board (4), wherein the second contact element (12), which is designed as a plug connection at one end, is inserted into a corresponding plug receptacle (4.1) in the printed circuit board (4) in order to establish an electrical and mechanical connection, and wherein the mechanical connecting element (16), which is arranged at the other end of the second contact element (12), is pressed into an aperture (5.1) in the intermediate base (5) of the controller.

6. Fluid assembly according to Claim 5, **characterized in that** the first contact element (11) comprises a cutting element (11.1), which establishes an electrical insulation-displacement connection to a coil wire of the magnet coil (2.3) in a corresponding connection dome (2.4), and a shaped mechanical connecting element (15) which mechanically connects the first contact element (11) to the corresponding connection dome (2.4) of the solenoid valve (2).

## Revendications

1. Élément de raccordement destiné à réaliser la jonction électrique d'une électrovanne avec une plaque conductrice, l'élément de raccordement (10) comprenant un premier élément de contact électrique (11) servant à la mise en contact électrique de l'électrovanne (2), un deuxième élément de contact électrique (12) servant à la mise en contact électrique de la plaque conductrice (4) et au moins un élément de compensation de la tolérance (13, 14), l'élément de raccordement (10) étant réalisé d'un seul tenant et le premier élément de contact électrique (11) et le deuxième élément de contact électrique (12) étant reliés entre eux via l'au moins un élément de compensation de la tolérance (13, 14), un premier élément de compensation de la tolérance (13) variable permettant une compensation de longueur dans au moins une direction dans l'espace, pour prescrire un positionnement dans l'espace souhaité du premier élément de contact (11) et du deuxième élément de contact (12) l'un par rapport à l'autre, le deuxième élément de contact (12) étant réalisé au niveau d'une extrémité sous la forme d'un raccordement de fiche mâle pouvant être introduit dans un logement de fiche mâle (4.1) correspondant prévu dans la plaque conductrice (4) en vue d'établir une liaison électrique et mécanique, **caractérisé en ce que** le deuxième élément de contact (12) prenant la forme d'un raccordement de fiche mâle comporte au niveau de l'autre extrémité un élément mécanique de liaison (16) à l'aide duquel le deuxième élément de contact (12) peut être comprimé dans un passage traversant (5.1) d'un fond intermédiaire (5), l'au moins un premier élément de compensation de la tolérance (13) s'étendant pour l'essentiel à angle droit par rapport à l'axe longitudinal du premier élément de contact (11) et par rapport à l'axe longitudinal du deuxième élément de contact (12), de sorte que les deux éléments de contact (11, 12) s'étendent pour l'essentiel parallèlement en décalé l'un par rapport à l'autre.

2. Élément de raccordement selon la revendication 1, **caractérisé en ce que** les deux éléments de contact (11, 12) transforment différents types de mise en contact à froid, les types de mise en contact à froid comprenant une liaison autodénudante et/ou une liaison par enfichage.

3. Élément de raccordement selon la revendication 1 ou 2, **caractérisé en ce que** l'élément de raccordement (10) prend la forme d'une pièce estampée réalisée d'un seul tenant.

4. Élément de raccordement selon l'une quelconque des revendications 1 à 3, **caractérisé en ce que** le premier élément de contact (11) comprend un élément tranchant (11.1) pouvant servir à établir une liaison autodénudante électrique avec un fil de bobine et un élément mécanique de liaison (15) rattaché, pour relier de façon mécanique le premier élément de contact (11) à un logement de contact (2.4) correspondant de l'électrovanne (2).

5. Système hydraulique doté d'un bloc hydraulique (3), d'une plaque conductrice (4) disposée dans un appareil de commande et d'au moins une électrovanne (2) comprenant un module aimanté (2.1) pourvu d'une bobine d'aimant (2.3) et de deux dômes de raccordement (2.4) et une cartouche de soupape (2.2) fixée dans le bloc hydraulique (3), le module aimanté (2.1) étant enfiché sur la cartouche de soupape (2.2) saillant au-delà du bloc hydraulique (3), **caractérisé en ce que** la bobine d'aimant (2.3) est reliée sur le plan électrique à la plaque conductrice (4) via au moins un élément de raccordement (10) selon l'une quelconque des revendications 1 à 4, le premier élément de contact (11) étant respectivement relié à un des dômes de raccordement (2.4) et le deuxième élément de contact électrique (12) étant relié à une région de contact (4.1) de la plaque conductrice (4), le deuxième élément de contact (12) réalisé sous la forme d'un raccordement de fiche mâle au niveau d'une extrémité étant introduit dans un logement de fiche mâle (4.1) correspondant prévu dans la plaque conductrice (4) en vue d'établir une liaison électrique et mécanique et l'élément de liaison mécanique (16) disposé au niveau de l'autre extrémité du deuxième élément de contact (12) étant comprimé dans un passage traversant (5.1) du fond intermédiaire (5) de l'appareil de commande.

6. Système hydraulique selon la revendication 5, **caractérisé en ce que** le premier élément de contact (11) comporte un élément tranchant (11.1) établissant une liaison autodénudante avec un fil de bobine de la bobine d'aimant (2.3) dans un dôme de raccordement (2.4) correspondant et un élément mécanique de liaison (15) rattaché reliant de façon mécanique le premier élément de contact (11) au dôme de raccordement (2.4) correspondant du module aimanté (2).
